# EUROPÄISCHE PATENTSCHRIFT

(11) **EP 0 309 720 B1**
(45) Veröffentlichungstag und Bekanntmachung des Hinweises auf die Patenterteilung: **02.03.1994**
(21) Anmeldenummer: 88113489.4
(22) Anmeldetag: 19.08.1988
(51) Int. Cl.: G01N 33/20, G01N 24/08

(54) **Verfahren zum Erzeugen von Spin-Echo-Impulsfolgen mit einem Kernspin-Tomographen und zur Durchführung des Verfahrens ausgebildeter Kernspin-Tomograph**
Process for producing spin echo impulse sequences with a nuclear spin tomograph and nuclear spin tomograph equipped for carrying out this process
Procédé pour la génération des séries d'impulsions écho de spin par un tomographe de spin nucléaire et tomographe de spin nucléaire accompli pour l'exécution de ce procédé

(30) Priorität: 09.09.1987 DE 3730148
(43) Veröffentlichungstag der Anmeldung: 05.04.1989
(73) Patentinhaber: Bruker Medizintechnik GmbH, D-76287 Rheinstetten (DE)
(72) Erfinder: Ratzel, Dieter, D-7512 Rheinstetten 4 (DE); Schuff, Norbert, Dr., D-6900 Heidelberg (DE)
(74) Vertreter: KOHLER SCHMID + PARTNER

(56) Entgegenhaltungen:
- EP-A- 0 138 270
- EP-A- 0 156 442
- EP-A- 0 164 199
- EP-A- 0 215 547
- EP-A- 0 244 843
- DE-A- 3 616 749
- DE-A- 3 724 962

## Beschreibung

Die Erfindung betrifft ein Verfahren zum Erzeugen von Spin-Echo-Impulsfolgen mit einem Kernspin-Tomographen, umfassend einen Magneten zum Erzeugen eines homogenen statischen Magnetfeldes, mindestens eine mit einem Kompensationsstrom beaufschlagte Hilfsspule zur Korrektur des statischen Magnetfeldes, mindestens eine Gradientenspule zum Erzeugen eines sich räumlich ändernden, zum statischen Magnetfeld gleichgerichteten Gradientenfeldes, die mit sich zeitlich ändernden Strömen beaufschlagbar ist, und mindestens eine HF-Spulenanordnung, der HF-Impulse zum Anregen von Kernspins eines sich in dem homogen statischen Magnetfeld befindenden Körpers zuführbar sind und die das Empfangen der von der angeregten Kernspins erzeugten Resonanzsignale gestattet, bei welchem Verfahren die Anregung der Kernspins mittels einer Folge von HF-Impulsen erfolgt, die einen ersten Anregungs-Impuls und eine sich anschließende Folge von zur Erzeugung von Spin-Echos dienenden HF-Impulsen umfaßt, in den Intervallen zwischen aufeinanderfolgenden HF-Impulsen der mindestens einen Gradientenspule Stromimpulse zugeführt werden und außerdem der Einfluß von durch die Erzeugung der Gradientenfelder erzeugten Wirbelströmen und anderen Ungenauigkeiten kompensiert wird.

Da bei der Kernspin-Tomographie die benötigten Gradientenfelder häufig ein- und ausgeschaltet werden müssen, tritt sowohl zu Beginn als auch zu Ende eines Gradienten-Impulses ein sehr schnell wechselndes Magnetfeld auf, das zu Abweichungen von dem gewünschten und berechneten Verhalten des Systems und den Ergebnissen des mit einem solchen Kernspin-Tomographen durchgeführten Verfahrens führt. Diese Störungen werden im wesentlichen auf die Anregung von Wirbelströmen durch die schnell wechselnden Magnetfelder, aber auch auf andere Ungenauigkeiten zurückgeführt. Als Folge davon entsteht ein nichtlinearer Verlauf des Gradientenfeldes, wie es in EP 01 56 442 A1 und EP 01 64 199 A1 beschrieben worden ist. Als Abhilfe sollen nach den genannten Druckschriften Maßnahmen getroffen werden, welche die genannten Nichtlinearitäten kompensieren. Eine dieser Maßnahmen besteht in der Anwendung einer weiteren Spulenanordnung, die ein zwar in Richtung des homogenen Magnetfeldes verlaufendes, jedoch sich örtlich nichtlinear änderndes Magnetfeld erzeugt. Dabei soll den Spulenanordnungen ein Strom zugeführt werden, der jeweils so bemessen ist, daß die Überlagerung der Magnetfelder der Spulenanordnungen dem gewünschten zeitlich-räumlichen Verlauf der Änderung der Magnetflußdichte des stationären Feldes ergibt. Mit anderen Worten, soll ein weiteres Spulensystem eingesetzt und derart mit Strömen beaufschlagt werden, daß die genannten Ungenauigkeiten kompensiert werden und das resultierende Feld den gewünschten räumlichen und zeitlichen Verlauf hat. In dem gleichen Sinne wirkt auch die andere, aus EP 01 64 199 A1 bekannte Maßnahme, die darin besteht, der Gradientenspule beim Einschalten einen Überschußstrom zuzuführen und Zeitkonstanten-Netzwerke anzuordnen, die für den Abfall des Wirbelstromfeldes charakteristisch sind, so daß auch hier wieder eine Kompensation des durch Wirbelströme bedingten Magnetfeldes durch ein künstlich zusätzlich erzeugtes Magnetfeld stattfindet.

Die vorstehend beschriebenen Maßnahmen zielen darauf ab, die durch das Induzieren von Wirbelströmen und sonstige Effekte verursachte, zeitliche und räumliche Feldverzerrung durch Erzeugen von zusätzlichen Feldern zu kompensieren, so daß die Summe aller Felder den gewünschten Feldverlauf ergibt. Diese Maßnahmen sind notwendigerweise sehr kompliziert, insbesondere dann, wenn bei dem Kernspin-Tomographen, wie allgemein üblich, mit drei zueinander senkrechten Gradientenfeldern gearbeitet wird, von denen jedes in anderer Weise von dem gewünschten Verlauf abweicht.

Die bei den bekannten Kernspin-Tomographen durch das Schalten der Gradientenfelder bedingten Feldverzerrungen haben u.a. zum Ergebnis, daß bei der Anwendung von Spin-Echo-Impulsfolgen die Amplitude der Echosignale sehr schnell abnimmt, so daß nur sehr wenige Spin-Echo-Signale empfangen werden können und daher die Anwendung von Spin-Echo-Impulsfolgen stark beeinträchtigt ist. Das schnelle Abklingen der Amplitude der Echosignale laßt darauf schließen, daß die Feldverzerrungen verhindern, daß die zur Erzeugung von Echosignalen erforderlichen Rephasierungs-Bedingungen erfüllt werden. Zwar könnte die Kompensation der zeitlichen und räumlichen Feldverzerrungen auch zur Folge haben, daß auch die Rephasierungs-Bedingungen erfüllt werden und eine große Anzahl von Echosignalen erhalten wird, jedoch sind, wie bereits oben erwähnt, die bisher bekannten Maßnahmen zur Kompensation der Feldverzerrung sehr kompliziert oder haben eine nur unzureichende Kompensation der Feldverzerrungen zur Folge, so daß trotz solcher Maßnahmen bei der Anwendung von Spin-Echo-Impulsfolgen keine ausreichend große Anzahl von Echosignalen erhalten wird, um die Vorteile solcher Spin-Echo-Impulsfolgen ausnutzen zu können.

Demgemäß liegt der Erfindung die Aufgabe zugrunde, die durch das Erzeugen von Wirbelströmen und anderen Ungenauigkeiten bedingten Feldverzerrungen mit geringem Aufwand in der Weise zu kompensieren, daß bei der Anwendung von Spin-Echo-Impulsfolgen eine Vielzahl von Echoimpulsen erhalten wird und daher die Vorteile, die in der Anwendung von solchen Spin-Echo-Impulsfolgen liegen, voll ausgenutzt werden können.

Diese Aufgabe wird nach der Erfindung dadurch gelöst, daß der Hilfsspule wenigstens im Zeitintervall zwischen dem Anregungs-Impuls und dem darauffolgenden HF-Impuls oder nur jeweils zwischen den zur Erzeugung von Spin-Echos dienenden HF-Impulsen ein Stromimpuls zugeführt wird, der eine solche zeitlich begrenzte Veränderung des statischen Magnetfeldes bewirkt, daß die dephasierende Wirkung auf die angeregten Kernspins, die durch die Änderung bedingt ist, die das statische Magnetfeld durch das Einschalten des wenigstens einen Gradientenfeldes erfährt, wenigstens annähernd aufgehoben wird.

Der Erfindung liegt die Erkenntnis zugrunde, daß es nicht notwendig ist, solche komplizierten Feldkorrekturen durchzuführen - was in der Praxis auch kaum möglich sein dürfte - sondern daß es ausreicht, die Störungen des homogenen Magnetfeldes zu kompensieren. Auch hierbei muß nicht das Feld zu jedem Zeitpunkt auf dem gewünschten Wert gehalten werden, sondern es ist für die Phasenlage der angeregten Kernspins nur das Zeitintegral über die Magnetfeldstärke, dem die Spins ausgesetzt sind, vom Zeitpunkt der Anregung an gerechnet, maßgebend. Es kommt daher für die Rephasierung nicht darauf an, wie der zeitliche Verlauf des Magnetfeldes im einzelnen ist, sondern nur darauf, daß das Zeitintegral der Magnetfeldstärke bestimmten Bedingungen genügt. Insbesondere muß das Zeitintegral der Magnetfeldstärke über das Zeitintervall zwischen dem Anregungs-Impuls und dem folgenden HF-Impuls halb so groß sein wie das Zeitintegral der Magnetfeldstärke über das Intervall zwischen den zur Erzeugung der Spin-Echos dienenden HF-Impulsen. Da dieses Zeitintegral ungeachtet der im einzelnen auftretenden Verzerrungen stets gleich ist, jedoch infolge der Verzerrungen von dem doppelten des Zeitintegrals der Magnetfeldstärke über dem Intervall zwischen dem Anregungs-Impuls und dem darauffolgenden HF-Impuls abweichen wird, genügt es, die Magnetfeldstärke in diesem ersten Intervall oder aber in allen übrigen Intervallen so zu ändern, daß die oben erwähnte Bedingung bezüglich der Integrale der Magnetfeldstärke uber die genannten Zeitintervalle eingehalten wird. Dies geschieht gemäß der oben erwähnten ersten Ausführungsform der Erfindung dadurch, daß das statische Magnetfeld mittels der üblicherweise zum Einstellen und Stabilisieren des Magnetfeldes auf einen vorgegebenen Wert vorhandenen Hilfsspule vergrößert oder verkleinert wird, bis die Rephasierungsbedingungen erfüllt sind. Dabei besteht ein besonderer Vorteil des erfindungsgemäßen Verfahrens darin, daß durch Beobachtung der Echosignale die Größe des Stromimpulses, der der Hilfsspule zugeführt werden muß, leicht experimentell bestimmt werden kann.

Die vorstehenden Betrachtungen, nach denen das Zeitintegral der Magnetfeldstärke über den Intervallen zwischen den HF-Impulsen für die Einhaltung der Rephasierungs-Bedingungen maßgeblich ist, lassen erkennen, daß anstelle der Zuführung eines Stromimpulses zu der Hilfsspule gemäß einer zweiten Ausführungsform der Erfindung auch der Abstand zwischen dem Anregungs-Impuls und dem darauffolgenden HF-Impuls auf einen solchen vom halben Abstand zwischen den folgenden HF-Impulsen abweichenden Wert eingestellt werden kann, daß wiederum die dephasierende Wirkung auf die angeregten Kernspins, die durch die Änderung bedingt ist, die das statische Magnetfeld durch das Einschalten des wenigstens einen Gradientenfeldes erfährt, wenigstens annähernd aufgehoben wird.

Auch hier ist ersichtlich, daß das Erscheinen von Spin-Echo-Impulsen als Kriterium für das Einstellen des optimalen Abstandes zwischen dem ersten Anregungs-Impuls und dem darauffolgenden HF-Impuls verwendet werden kann.

Ein besonderer Vorteil des erfindungsgemäßen Verfahren besteht darin, daß keine komplizierten Spulenanordnungen benötigt werden, um etwa nichtlineare Felder zu erzeugen, und daß es außerdem auf die Form und Dauer des Stromimpulses im einzelnen nicht ankommt, sondern nur auf die Gesamtwirkung dieses Stromimpulses. So kann bei vorgegebener Dauer des Stromimpulses auch die Stromstärke variiert werden. Damit hängt auch zusammen, daß die Wirkung sämtlicher Gradientenfelder berücksichtigt wird, ohne daß die speziellen Eigenschaften der einzelnen Gradientenfelder beachtet werden mußten. Außerdem besteht im allgemeinen ein lineares Verhältnis zwischen der zur Erzeugung eines Gradientenfeldes verwendeten Stromstärke und der Stromstärke bzw. der Zeitdauer des Stromflusses durch die Hilfsspule bzw. des zeitlichen Abstandes zwischen dem Anregungs-Impuls und dem folgenden HF-Impuls gegenüber dem halben Abstand zwischen den folgenden HF-Impulsen der Impulsfolge. Daher sieht eine bevorzugte Ausführungsform der Erfindung vor, daß die Größe des Stromimpulses bzw. die Änderung des Abstandes zwischen dem Anregungs-Impuls und dem folgenden HF-Impuls gegenüber dem halben Abstand zwischen den folgenden HF-Impulsen der Größe des wenigstens einen Gradientenfeldes proportional ist.

Dieses Merkmal ist besonders für solche Verfahren interessant, bei denen ein Phasengradient Verwendung findet, dessen Größe für jede Anregung wenigstens einmal schrittweise geändert wird. In diesem Fall kann dann die Größe des Stromimpulses bzw. die Änderung des Abstandes zwischen dem Anregungs-Impuls und dem folgenden HF-Impuls gegenüber dem halben Abstand zwischen den folgenden HF-Impulsen der Größe des Phasengradienten proportional sein. Dabei sei nochmals bemerkt, daß unter "Größe des Stromimpulses" das Integral der Stromstärke über die Impulsdauer verstanden werden soll.

Aus den vorstehenden Betrachtungen folgt weiter, daß das erfindungsgemäße Verfahren auch dann mit Vorteil Anwendung finden kann, wenn nicht nur die Größe eines Gradienten, insbesondere des Phasengradienten, für jede Anregung geändert wird, sondern wenn der Gradient nach jeder Anregung in einem oder mehreren der Intervalle der Folge von HF-Impulsen geändert wird, wie es beispielsweise bei Schnellbildverfahren der Fall ist. Dann ist es natürlich im allgemeinen nicht mehr ausreichend, nur zwischen dem Anregungs-Impuls und dem darauffolgendem HF-Impuls der Hilfsspule einen Stromimpuls zuzuführen, sondern es muß im Verlauf einer Impulsfolge jeder Änderung des Phasengradienten ein der Hilfsspule zugeführter Stromimpuls zugeordnet sein, auch wenn dann der Impuls zwischen dem Anregungs-Impuls und dem darauffolgenden HF-Impuls entfallen kann. Wenn, wie es zur Erfüllung der Rephasierungsbedingungen in der Regel der Fall ist, der Phasengradient in jedem Intervall zwischen zwei HF-Impulsen vor und nach dem Auftreten des Echosignals mit entgegengesetzten Vorzeichen eingeschaltet wird, wird zweckmäßigerweise bei jedem Einschalten des Phasengradienten auch der Hilfsspule ein Stromimpuls mit einem dem Vorzeichen des eingeschalteten Phasengradienten entsprechenden Vorzeichen zugeführt.

Kernspin-Tomographen dienen gewöhnlich dazu, Querschnittsbilder eines größeren Körpers zu erzeugen. Hierzu ist es notwendig, aus dem Körper eine Scheibe zu selektieren, die das Querschnittsbild liefern soll. Zu diesem Zweck findet eine Scheibenselektions-Gradient Anwendung, der während des Auftretens des Anregungs-Impulses eingeschaltet ist. Auch der Scheibenselektions-Gradient kann zu unerwünschten Dephasierungen Anlaß geben, die durch einen Anteil mit umgekehrtem Vorzeichen aufgehoben werden, der im Zeitintervall zwischen dem Anregungs-Impuls und dem darauffolgendem HF-Impuls eingeschaltet wird. Wenn die Erfindung bei einem Verfahren Anwendung findet, bei dem von einem solchen Scheibenselektions-Gradienten Gebrauch gemacht wird, dem ein Anteil mit umgekehrtem Vorzeichen folgt, so kann in besonders vorteilhafter Weise der der Hilfsspule zugeführte Stromimpuls gleichzeitig zum Auftreten des Anteils des Scheibenselektions-Gradienten mit umgekehrtem Vorzeichen erzeugt werden.

Weiterhin ist es zweckmäßig, bei der Einleitung des erfindungsgemäßen Verfahrens schon vor dem Einstrahlen wenigstens der ersten HF-Impulsfolge die im Verlauf der HF-Impulsfolge zu schaltenden Gradienten wenigstens einmal einzuschalten, damit auf diese Weise eine Art stationärer Zustand erreicht wird, bei dem die durch Wirbelströme und sonstige Ungenauigkeiten bedingten Störungen einen vorgegebnen, festen Wert haben, der dann nach dem erfindungsgemäßen Verfahren sehr einfach und mit sehr hoher Stabilität ausgeglichen werden kann.

Die Erfindung hat auch einen Kernspin-Tomographen zum Gegenstand, der einen Magneten zum Erzeugen eines homogenen statischen Magnetfeldes, mindestens eine mit einem Kompensationsstrom beaufschlagbare Hilfsspule zur Korrektur des statischen Magnetfeldes, eine erste Einrichtung zum Erzeugen des der Hilfsspule zuzuführenden Stromes, mindestens eine Gradientenspule zum Erzeugen eines sich räumlich ändernden, zum statischen Magnetfeld gleichgerichteten Gradientenfeldes, eine zweite Einrichtung zum Zuführen von sich zeitlich ändernden Strömen zu der mindestens einen Gradientenspule, mindestens eine HF-Spulenanordnung, eine dritte Einrichtung zum Erzeugen von HF-Impulsen, die der HF-Spulenanordnung zum Anregen der Kernspins eines sich in dem homogenen statischen Magnetfeld befindenden Körpers zuführbar sind und einen ersten Anregungs-Impuls und eine sich daran anschließende Folge von HF-Impulsen umfassen, und eine vierte Einrichtung zum Empfangen der von den angeregten Kernspins erzeugten Resonanzsignale umfasst.

Ein solcher Kernspin-Tomograph kann zur Durchfuhrung des erfindungsgemäßen Verfahrens in der Weise ausgebildet sein, daß die zweite Einrichtung zum Erzeugen eines für die Stärke und/oder Dauer des der mindestens einer Gradientenspule zugeführten Stromes charakteristischen Signales ausgebildet ist und dieses Signal der ersten Einrichtung zum Steuern des der Hilfsspule zugeführten Stromes bzw. der dritten Einrichtung zum Steuern des Abstandes zwischen dem ersten und dem zweiten HF-Impuls zugeführt wird.

Diese Ausbildung eines Kernspin-Tomographen zeichnet sich durch einen sehr einfachen Aufbau aus, weil unmittelbar das zum Auslösen eines veränderlichen Gradienten dienende Signal auch dazu benutzt wird, die Größe des der Hilfsspule zuzuführenden Stromes bzw. die Einstellung des Abstandes zwischen dem ersten und dem zweiten HF-Impuls zu steuern. Dabei lassen entsprechende Schalteinrichtungen nicht nur das Einhalten einer strengen Proportionalität, sondern auch beliebiger funktioneller Zusammenhänge zu, die in der oben erläuterten Weise experimentell ermittelt werden können.

Bei einer bevorzugten Ausführungsform eines solchen Kernspin-Tomographen weist die erste Einrichtung eine Torschaltung und einen ersten, die Hilfsspule speisenden Leistungsverstärker auf, während die zweite Einrichtung zum Erzeugen von Stromimpulsen ausgebildet ist und einen zweiten, die Gradientenspule speisenden Leistungsverstärker aufweist, dem die Stromimpulse zur Erzeugung des Gradientenfeldes zugeführt werden. Die Stromimpulse werden außerdem der Torschaltung der ersten Einrichtung zugeführt, die ausgewählte Stromimpulse zu dem ersten Leistungsverstärker überträgt, dessen Verstärkungsfaktor auf das gewünschte Verhältnis der die Gradientenspule und die Hilfsspule durchfließenden Ströme eingestellt ist.

Analog kann dann, wenn der zeitliche Abstand zwischen dem Anregungs-Impuls und dem folgenden HF-Impuls verändert werden soll, die dritte Einrichtung ein diesen zeitlichen Abstand steuerndes Zeitglied aufweisen und die zweite Einrichtung zum Erzeugen von Stromimpulsen ausgebildet sein und einen die Gradientenspule speisenden Leistungsverstärker aufweisen, dem die Stromimpulse zur Erzeugung des Gradientenfeldes zugeführt werden. Außerdem werden die Stromimpulse dem Zeitglied der dritten Einrichtung zugeführt, das eine Änderung der Größe des genannten Zeitintervalles proportional zur Größe des jeweiligen Stromimpulses bewirkt.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen
- Fig. 1: die schematische Darstellung eines nach der Erfindung ausgebildeten Kernspin-Tomographen und
- Fig. 2: das Impulsdiagramm einer Ausführungsform des erfindungsgemäßen Verfahrens, das mit dem Kernspin-Tomographen nach Fig. 1 durchführbar ist.

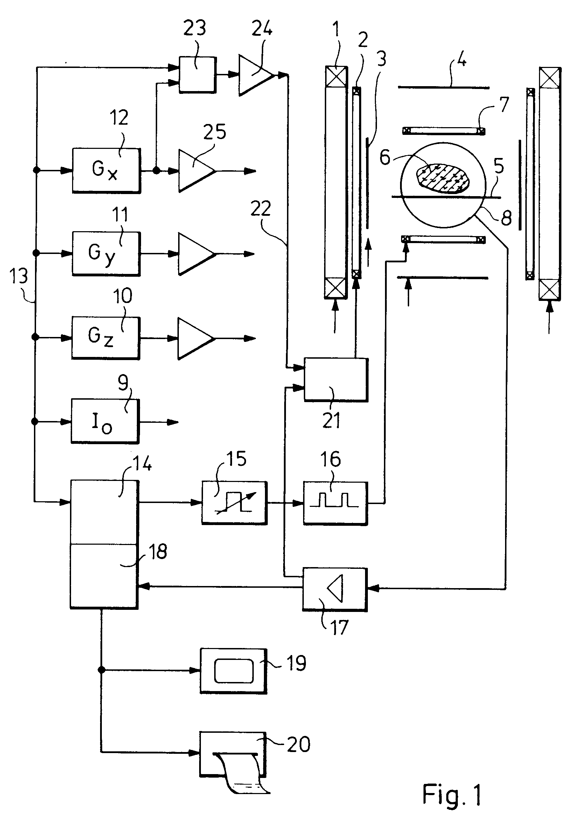

Der in Fig. 1 dargestellte Kernspin-Tomograph weist ein erstes Magnetspulensystem 1 zur Erzeugung eines homogenen Magnetfeldes auf. Bei diesem Magnetspulensystem 1 kann es sich um ein supraleitendes oder resistives Solenoid- oder Doppel-Helmholtz-System handeln. Diesem ersten Magnetspulensystem ist eine Hilfsspule 2 zugeordnet, beispielsweise in Form eines einfachen Helmholtz-Systems, das ein zu dem vom ersten Magnetspulensystem 1 gleich oder entgegengerichtetes, ebenfalls homogenes Magnetfeld erzeugt, mit dem die Größe des vom Magnetspulensystem 1 erzeugten Hauptfeldes veränderbar ist, insbesondere zum Zweck der Feldstabilisierung.

Der dargestellte Kernspin-Tomograph weist weiterhin drei Gradientenspulen auf, von denen in Fig. 1 zwei Gradientenspulen 3 und 4 veranschaulicht sind, von denen die eine Gradientenspule 3 eine Variation des statischen Magnetfeldes in z-Richtung und die andere Gradientenspule 4 eine Variation in x-Richtung bewirkt. Eine weitere, wegen der schematischen Darstellung nicht wiedergegebene Gradientenspule bewirkt eine Änderung des homogenen Magnetfeldes in y-Richtung. Ein Probenhalter 5 gestattet es, eine Probe 6 in das Zentrum der Spulenanordnung zu bringen, in dem ein homogenes Magnetfeld herrscht, dem die möglichst linearen Gradientenfelder überlagert sind. Oberhalb und unterhalb der Probe 5 befinden sich Sendespulen 7, deren Achse senkrecht zur Achse des ersten Magnetspulensystems 1 steht. Zu diesen beiden Achsen wiederum senkrecht sind Empfangsspulen 8 angeordnet.

Ein Netzgerät 9 dient zur Versorgung des ersten Magnetspulensystems 1, wahrend weitere Netzgeräte 10, 11, 12 zur Versorgung der Gradientenspulen 3, 4 usw. dienen. Der Übersichtlichkeit halber sind in Fig. 1 die dazu notwendigen Verbindungen nicht im einzelnen dargestellt.

Den Netzgeräten 9 bis 12 werden über eine Steuerleitung 13 von einer Steuereinheit 14 Steuersignale zugeführt, welche die Stärke des die einzelnen Spulen durchfließenden Stromes sowie auch die Dauer des Stromflusses bestimmen. Die Steuereinheit 14 betätigt außerdem über ein Einstellorgan 15 einen HF-Impulsgenerator 16, an den die Sendespule 7 angeschlossen ist. In entsprechender Weise sind die Empfangsspulen 8 an einen HF-Empfänger 17 angeschlossen, dessen Ausgangssignal einer Auswerteeinheit 18 zugeführt wird. An den Ausgang dieser Auswerteeinheit 18 sind ein Bildschirm 19 und eine Plotter 20 angeschlossen.

Die Hilfsspule 2 ist bei dem dargestellten Ausführungsbeispiel Bestandteil eines sogenannten "Feldlock", bei dem mittels des HF-Empfängers 17 die Frequenz einer sich im homogenen Magnetfeld befindenden, ausgewählten Kernart überwacht und der Hilfsspule 2 über eine Summierschaltung ein solcher Strom zugeführt wird, daß die Frequenz der ausgewählten Kernart auf einem vorgegebenen Wert gehalten wird. Gleichzeitig wird die Hilfsspule 2 von einem der Summierschaltung 21 über eine Leitung 22 zugeführten Strom beaufschlagt, der dem Strom proportional ist, der von dem Netzgerät 12 der Gradientenspule für die x-Richtung zugeführt wird. Dabei wird das Ausgangssignal des Netzgerätes 12 über eine Torschaltung 23, deren Öffnungsintervalle von der Steuereinheit 14 bestimmt werden, einem Leistungsverstärker 24 zugeführt, der den Strom für die Hilfsspule 2 erzeugt. Dabei bestimmt der Verstärkungsfaktor des Leistungsverstärkers 24 im Verhältnis zu dem Verstärkungsfaktor des Leistungsverstärkers 25, der an den Ausgang des Netzgerätes 12 für die x-Gradientenspulen angeschlossen ist, wie stark das Verhältnis des von der Hilfsspule 2 kurzfristig erzeugten Magnetfeldes zur Stärke des x-Gradientenfeldes ist.

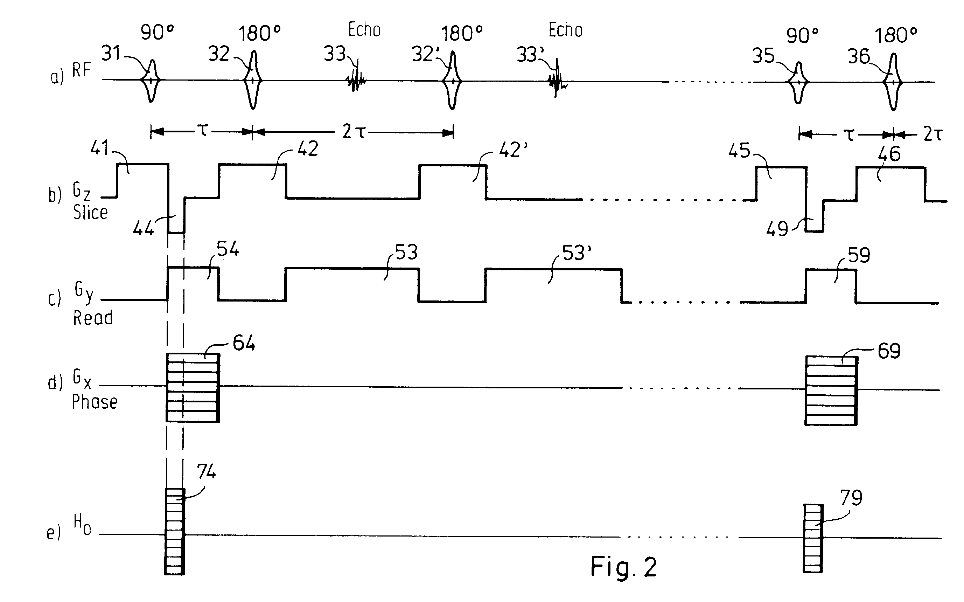

Mit der in Fig. 1 schematisch dargestellten Ausführungsform eines Kernspin-Tomographen läßt sich das anhand von Fig. 2 veranschaulichte Verfahren ohne weiteres durchführen.

Der HF-Impulsgenerator 16 erzeugt unter dem Einfluß von Steuersignalen, die von der Steuereinheit 14 geliefert werden, die in Zeile (a) der Fig. 2 veranschaulichte Folge von HF-Impulsen, die einen Anregungs-Impuls in Form eines ersten 90°-Impulses 31 und daran anschließend eine Folge von zur Erzeugung von Spin-Echos dienenden HF-Impulsen umfaßt, die bei dem dargestellten Ausführungsbeispiel von 180°-Impulsen 32, 32′ usw. gebildet werden. Der Abstand zwischen den 180°-Impulsen 32, 32′ ist doppelt so groß wie der Abstand τ zwischen dem ersten 90°-Impuls 31 und dem folgenden 180°-Impuls 32. Unter Einhaltung der bekannten Rephasierungs-Bedingungen erscheint in der Mitte zwischen jeweils zwei aufeinanderfolgenden 180°-Impulsen ein Echoimpuls 33, 33′ usw.

Zum Zwecke der Bilddarstellung, wie sie die Kernspin-Tomographie anstrebt, werden z.B. nur die in einer zur z-Richtung, d.h. der Richtung des homogenen Magnetfeldes senkrechten Scheibe vorhandenen Kernspins angeregt. Diese selektive Anregung wird durch Einschalten eines z-Gradienten G_{z} während des Einstrahlens des 90°-Impulses 31 erreicht. Einschaltdauer und Stärke des Gradientenfeldes werden durch den impulsartigen Abschnitt 41 veranschaulicht. Außerdem wird der Scheiben- oder Selektionsgradient G_{z} jeweils während des Auftretens der 180°-Impulse eingeschaltet, wie es die impulsartigen Abschnitte 42, 42′ anzeigen. Da der Selektionsgradient 41 nur auf die durch den 90°-Impuls 31 angeregten Spins wirkt und in soweit eine dephasierende Wirkung hat, folgt dem während des 90°-Impulses 31 eingeschalteten Anteil des z-Gradienten ein Anteil 44 mit ungekehrtem Vorzeichen.

Eine Auflösung der innerhalb der Scheibe angeregten Spins in y-Richtung wird durch einen Lesegradienten erzielt, der jeweils symmetrisch zum Auftreten der Echosignale 33, 33′ eingeschaltet wird, wie es die impulsartigen Abschnitte 53, 53′ in Zeile (c) der Fig. 2 zeigen. Das Einhalten der Rephasierungsbedingungen erfordert, daß der Lesegradient auch im Intervall zwischen dem 90°-Impuls 31 und dem darauffolgenden 180°-lmpuls 32 eingeschaltet wird, wie es der Abschnitt 54 in Zeile (c) der Fig. 2 zeigt.

Endlich ist es zur Bilderzeugung auch noch erforderlich, eine Auflösung des Bildes in x-Richtung vorzunehmen. Zu diesem Zweck wird im Bereich zwischen dem 90°-Impuls und dem darauffolgenden 180°-Impuls ein x-Gradient Gₓ eingeschaltet, der auch als Phasen-Codierungs-Gradient bezeichnet wird. Die parallelen Striche in dem das Einschalten des x-Gradienten anzeigenden Kasten 64 in Zeile (d) zeigt an, daß die Größe des x-Gradienten nach jeder neuen Anregung geändert wird.

Fig. 2 zeigt eine weitere Anregung, die der ersten Anregung durch den 90°-Impuls 31 folgt und ebenfalls einen ersten 90°-Impuls 35 und darauffolgende 180°-Impulse 36 umfaßt, von denen lediglich der erste dargestellt ist. Dieser Impulsfolge sind wiederum die entspechenden Gradienten zugeordnet, beginnend mit dem z-Gradienten in Zeile (b) mit seinen Abschnitten 45, 46, 49, gefolgt von dem Lesegradienten mit seinem Abschnitt 59 und den weiteren, nicht mehr dargestellten Abschnitten und endlich auch dem Phasen-Codierungs-Gradienten 69 in Zeile (d), dessen Größe, wie erwähnt, von der Größe des Phasen-Codierungs-Gradienten 64 der vorhergehenden Anregung abweicht. Insoweit handelt es sich um ein übliches Spin-Echo-Verfahren, das dem Fachmann in allen Einzelheiten gut bekannt ist.

Nach der Erfindung wird in dem gleichen Zeitintervall, während dem der Anteil 44 bzw. 49 des z-Gradienten erzeugt wird, der Hilfsspule 2 ein Strom 74 bzw. 79 zugeführt, dessen Größe der Größe des Phasengradienten 64 bzw. 69 proportional ist (siehe Figur 2, Zeile (e)). Wie bereits oben erwähnt, wird, um diesen Strom zu erzeugen, das gleiche Signal, das dem Leistungsverstärker 25 zur Erzeugung des Stromes, der der z-Gradientenspule zugeführt wird, über die Torschaltung 23 auch dem Leistungsverstärker 24 zugeührt, dessen Ausgang über die Summierschaltung 21 mit der Hilfsspule 2 verbunden ist und die Hilfsspule mit einem Strom speist, dessen Dauer von der Öffnungszeit der Torschaltung 23 und dessen Stärke von der Größe des zugeführten Steuersignals und dem Verstärkungsfaktor des Leistungsverstärker 24 abhängt. Wie erwähnt, bewirkt die Steuereinheit 14 das Öffnen des Torschalters 23 für die Dauer des negativen Abschnittes 44 des Scheibenselektions-Gradienten gemäß Zeile (b) in Fig. 2. Der Verstärkungsfaktor des Leistungsverstärker 24 wird unter Beobachtung der Echosignale 33 ,33′ so eingestellt, daß eine maximale Anzahl von Echosignalen erzielt wird. Dabei wird der der Hilfsspule 2 zugeführte Strom stets proportional zur Größe des Phasencodierungs-Gradienten eingestellt. Auf diese Weise bleiben die durch Erzeugen des zusätzlichen Magnetfeldes mittels der Hilfsspule 2 eingestellten Rephasierungsbedingungen für alle möglichen Werte des Phasencodierung-Gradienten erhalten.

Wie oben erläutert, können die Rephasierungsbedingungen auch dadurch hergestellt werden, daß anstelle des statischen Magnetfeldes der Abstand zwischen dem Anregungs-Impuls und dem darauffolgenden, der Erzeugung von Spin-Echos dienenden HF-Impuls geändert wird, während die Abstände zwischen den übrigen HF-Impulsen unverändert bleiben. In diesem Fall könnte bei dem Kernspin-Tomographen nach Fig. 1 das Einstellorgan 15 in Abhängigkeit von der Größe des Phasencodierungs-Gradienten Gₓ in der Weise beeinflußt werden, daß der Abstand zwischen dem ersten 90°-Impuls und dem folgenden 180°-Impuls geändert wird.

Es versteht sich ferner, daß die Größe des die Hilfsspule durchfließenden Stromes bzw. des Abstandes zwischen dem Anregungs-Impuls und dem HF-Impuls nicht allein von dem Phasencodierungs-Gradienten, sondern von der Größe aller Gradienten abhängt. Dementsprechend kann der Strom ebenso wie der Abstand aus einem bestimmten Grundbetrag bestehen und nur die Änderung dem sich ändernden Gradienten proportional sein.

Endlich sind Impulsfolgen bekannt, bei denen beispielsweise der Phasencodierungs-Gradient nicht nur nach jedem Anregungs-Impuls einer Impulsfolge, sondern auch zwischen jeweils zwei aufeinanderfolgenden HF-Impulsen geändert wird, was in einem Schnellverfahren die Aufnahme eines vollständigen Bildes aufgrund einer einzigen Anregung ermoglicht. In einem solchem Fall kann natürlich mit einer Änderung des zeitlichen Abstandes zwischen dem Anregungs-Impuls und dem HF-lmpuls nicht mehr gearbeitet werden, jedoch kann dann in jedem Intervall zwischen zwei aufeinanderfolgenden HF-Impulsen die Hilfsspule mit einem Strom beaufschlagt werden, der sich entsprechend der Größe des Phasencodierungs-Gradienten ändert. Es wäre aber auch denkbar, statt dessen die Länge der Intervalle zwischen den aufeinanderfolgenden HF-Impulsen zu variieren.

Der Vollständigkeit halber sei auch noch erwähnt, daß die Erfindung in Verbindung mit allen möglichen Spin-Echo-Impulsfolgen Anwendung finden kann, wie beispielsweise auch Folgen von 90°-Impulsen zur Erzeugung stimulierter Echos, wie sie von Frahm et al im Journal of Magnetic Resonance, Vol. 64, 1985, S. 81 bis 93, beschrieben sind.

## Patentansprüche

1. Verfahren zum Erzeugen von Spin-Echo-Impulsfolgen mit einem Kernspin-Tomographen, umfassend einen Magneten (1) zum Erzeugen eines homogenen statischen Magnetfeldes, mindestens eine mit einem Kompensationsstrom beaufschlagte Hilfsspule (2) zur Korrektur des statischen Magnetfeldes durch ein räumlich homogenes Korrekturfeld, mindestens eine Gradientenspule (3) zum Erzeugen eines sich räumlich ändernden, zum statischen Magnetfeld gleichgerichteten Gradientenfeldes, die mit sich zeitlich ändernden Strömen beaufschlagbar ist, und mindestens eine HF-Spulenanordnung (7, 8), der HF-Impulse zum Anregen von Kernspins eines sich in dem homogenen statischen Magnetfeld befindenden Körpers zuführbar sind und die das Empfangen der von den angeregten Kernspins erzeugten Resonanzsignale gestattet, bei welchem Verfahren die Anregung der Kernspins mittels einer Folge von HF-Impulsen erfolgt, die einen ersten Anregungs-Impuls und eine sich anschließende Folge von zur Erzeugung von Spin-Echos dienenden HF-Impulsen umfaßt, in den Intervallen zwischen aufeinanderfolgenden HF-Impulsen der mindestens einen Gradientenspule Stromimpulse zugeführt werden und außerdem der Einfluß von durch die Erzeugung der Gradientenfelder erzeugten Wirbelströmen und anderen Ungenauigkeiten kompensiert wird,
dadurch gekennzeichnet, daß
der Hilfsspule (2) wenigstens im Zeitintervall zwischen dem Anregungs-Impuls (31) und dem darauffolgenden HF-Impuls (32) oder nur jeweils zwischen den HF-Impulsen ein Stromimpuls (74) zugeführt wird, der eine solche zeitlich begrenzte, räumlich homogene Veränderung des statischen Magnetfeldes bewirkt, daß die dephasierende Wirkung auf die angeregten Kernspins, die durch die Änderung bedingt ist, die das statische Magnetfeld durch das Einschalten des wenigstens einen Gradientenfeldes (64) erfährt, wenigstens annähernd aufgehoben wird.

2. Verfahren zum Erzeugen von Spin-Echo-Impulsfolgen mit einem Kernspin-Tomographen, umfassend einen Magneten (1) zum Erzeugen eines homogenen statischen Magnetfeldes durch ein räumlich homogenes Korrekturfeld, mindestens eine mit einem Kompensationsstrom beaufschlagte Hilfsspule (2) zur Korrektur des statischen Magnetfeldes, mindestens eine Gradientenspule (3) zum Erzeugen eines sich räumlich ändernden, zum statischen Magnetfeld gleichgerichteten Gradientenfeldes, die mit sich zeitlich ändernden Strömen beaufschlagbar ist, und mindestens eine HF-Spulenanordnung (7, 8), der HF-Impulse zum Anregen von Kernspins eines sich in dem homogenen statischen Magnetfeld befindenden Körpers zuführbar sind und die das Empfangen der von den angeregten Kernspins erzeugten Resonanzsignale gestattet, bei welchem Verfahren die Anregung der Kernspins mittels einer Folge von HF-Impulsen erfolgt, die einen ersten Anregungs-Impuls und eine sich anschließende Folge von zur Erzeugung von Spin-Echos dienenden HF-Impulsen umfaßt, in den Intervallen zwischen aufeinanderfolgenden HF-Impulsen der mindestens einen Gradientenspule Stromimpulse zugeführt werden und außerdem der Einfluß von durch die Erzeugung der Gradientenfelder erzeugten Wirbelströmen und anderen Ungenauigkeiten kompensiert wird,
dadurch gekennzeichnet, daß
der Abstand zwischen dem Anregungs-Impuls (31) und dem darauf folgenden HF-Impuls (32) auf einen solchen vom halben Abstand zwischen den folgenden HF-Impulsen (32, 33') abweichenden Wert eingestellt wird, daß die dephasierende Wirkung auf die angeregten Kernspins, die durch die Änderung bedingt ist, die das statische Magnetfeld durch das Einschalten des wenigstens einen Gradientenfeldes erfährt, wenigstens annähernd aufgehoben wird.

3. Verfahren nach Anspruch 1 oder 2, dadurch gekennzeichnet, daß die Größe des Stromimpulses (74) bzw. die Änderung des Abstandes zwischen dem Anregungs-Impuls und dem folgenden HF-Impuls gegenüber dem halben Abstand zwischen den folgenden HF-Impulsen der Größe des wenigstens einen Gradientenfeldes (64) proportional ist.

4. Verfahren nach Anspruch 3, bei dem ein Phasengradient Verwendung findet, dessen Größe für jede Anregung wenigstens einmal schrittweise geändert wird, dadurch gekennzeichnet, daß die Größe des Stromimpulses (74) bzw. die Änderung des Abstandes zwischen dem Anregungs-Impuls und dem folgenden HF-Impuls (32) gegenüber dem halben Abstand zwischen den folgenden HF-Impulsen der Größe des Phasengradienten (64) proportional ist.

5. Verfahren nach Anspruch 1, bei dem ein Scheibenselektions-Gradient Anwendung findet, der im Zeitintervall zwischen dem Anregungs-Impuls und dem darauf folgenden HF-Impuls einen Anteil mit umgekehrtem Vorzeichen aufweist, dadurch gekennzeichnet, daß der der Hilfsspule (2) zugeführte Stromimpuls (74) gleichzeitig zum Auftreten des Anteils (44) des Scheibenselektions-Gradienten mit umgekehrtem Vorzeichen erzeugt wird.

6. Verfahren nach einem der vorhergehenden Ansprüche unter Verwendung eines Phasengradienten, der nach jeder Anregung in einem oder mehreren der Intervalle der Folge von HF-Impulsen geändert wird, dadurch gekennzeichnet, daß jeder Änderung des Phasengradienten ein der Hilfsspule zugeführter Stromimpuls zugeordnet ist.

7. Verfahren nach Anspruch 6, bei dem der Phasengradient in jedem Intervall zwischen zwei HF-Impulsen vor und nach dem Auftreten des Echosignals mit entgegengesetzten Vorzeichen eingeschaltet wird, dadurch gekennzeichnet, daß bei jedem Einschalten des Phasengradienten auch der Hilfsspule ein Stromimpuls mit einem dem Vorzeichen des eingeschalteten Phasengradienten entsprechenden Vorzeichen zugeführt wird.

8. Verfahren nach einem der vorhergehenden Ansprüche, dadurch gekennzeichnet, daß vor dem Einstrahlen wenigstens der ersten HF-Impulsfolge die im Verlauf der HF-Impulsfolge zu schaltenden Gradienten wenigstens einmal eingeschaltet werden.

9. Kernspin-Tomograph mit einem Magneten (1) zum Erzeugen eines homogenen statischen Magnetfeldes, mit mindestens einer mit einem Kompensationsstrom beaufschlagbaren Hilfsspule (2) zur Korrektur des statischen Magnetfeldes durch ein räumlich homogenes Korrekturfeld, mit einer ersten Einrichtung (17, 21) zum Erzeugen des der Hilfsspule zuzuführenden Stromes, mit mindestens einer Gradientenspule (3) zum Erzeugen eines sich räumlich ändernden, zum statischen Magnetfeld gleichgerichteten Gradientenfeldes, mit einer zweiten Einrichtung (12, 25) zum Zuführen von sich zeitlich ändernden Strömen zu der mindestens einen Gradientenspule, mit mindestens einer HF-Spulenanordnung (7), mit einer dritten Einrichtung (14, 15, 16) zum Erzeugen von HF-Impulsen, die der HF-Spulenanordnung zum Anregen der Kernspins eines sich in dem homogenen statischen Magnetfeld befindenden Körpers zuführbar sind und einen ersten Anregungs-Impuls und eine sich daran anschließende Folge von zur Erzeugung von Spin-Echos dienenden HF-Impulsen umfassen, und mit einer vierten Einrichtung (8, 17, 18) zum Empfangen der von den angeregten Kernspins erzeugten Resonanzsignale,
dadurch gekennzeichnet, daß
die zweite Einrichtung (12, 25) zum Erzeugen eines für die Stärke und/oder Dauer des der mindestens einen Gradientenspule zugeführten Stromes charakteristischen Signales ausgebildet ist und dieses Signal zur Durchführung des Verfahrens nach einem der vorhergehenden Ansprüche, der ersten Einrichtung (23, 24) zum Steuern des der Hilfsspule (22) zugeführten Stromes bzw. der dritten Einrichtung zum Steuern des Abstandes zwischen dem ersten und dem zweiten HF-Impuls zugeführt wird.

10. Kernspin-Tomograph nach Anspruch 9, dadurch gekennzeichnet, daß die erste Einrichtung eine Torschaltung (22) und einen ersten, die Hilfsspule (2) speisenden Leistungsverstärker (24) aufweist und die zweite Einrichtung (12, 25) zum Erzeugen von Stromimpulsen ausgebildet ist und einen zweiten, die Gradientenspule speisenden Leistungsverstärker (25) aufweist, dem die Stromimpulse zur Erzeugung des Gradientenfeldes zugeführt werden, und daß die Stromimpulse außerdem der Torschaltung ( 23) der ersten Einrichtung (23, 24) zugeführt werden, die ausgewählte Stromimpulse zu dem ersten Leistungsverstärker (24) überträgt, dessen Verstärkungsfaktor auf das gewünschte Verhältnis der die Gradientenspule und die Hilfsspule durchfließenden Ströme eingestellt ist.

11. Kernspin-Tomograph nach Anspruch 9, dadurch gekennzeichnet, daß die dritte Einrichtung ein den zeitlichen Abstand zwischen dem Anregungs-Impuls und dem folgenden HF-Impuls steuerndes Zeitglied aufweist und die zweite Einrichtung zum Erzeugen von Stromimpulsen ausgebildet ist und einen die Gradientenspule speisenden Leistungsverstärker aufweist, dem die Stromimpulse zur Erzeugung des Gradientenfeldes zugeführt werden, und daß die Stromimpulse außerdem dem Zeitglied der dritten Einrichtung zugeführt werden, das eine Änderung der Größe des genannten Zeitintervalles proportional zur Größe des jeweiligen Stromimpulses bewirkt.

## Claims

1. Method for generating spin echo pulse sequences in a nuclear spin tomograph, comprising a magnet (1) for generating a homogeneous static magnetic field, at least one auxiliary coil (2) to which a compensation current is applied, for correction of the static magnetic field by means of a spatially homogeneous correction field, at least one gradient coil (3) for generating a gradient field varying in space and directed in the same direction as the static magnetic field, which gradient coil can be subjected to currents varying over time, and at least one rf coil arrangement (7, 8) to which rf pulses can be supplied for exciting nuclear spins of a body located in the homogeneous static magnetic field and permitting the resonance signals generated by the excited nuclear spins to be received, in which method the excitation of the nuclear spins is accomplished by means of a sequence of rf pulses comprising a first excitation pulse and a subsequent sequence of rf pulses serving for generating spin echoes, current pulses are applied to the at least one gradient coil in the intervals between successive rf pulses, and furthermore the influence of the eddy currents and other inaccuracies produced by the generation of the gradient fields is compensated,
characterized in that
a current pulse (74) is applied to the auxiliary coil (2), at least in the time interval between the excitation pulse (31) and the next following rf pulse (32) or only between each of the rf pulses which current pulse effects a spatial homogeneous variation of the static magnetic field limited in time so as to balance out, at least approximately, the dephasing effect on the excited nuclear spins resulting from the variation to which the static magnetic field is subjected by the insertion of the at least one gradient field (64).

2. Method for generating spin echo pulse sequences in a nuclear spin tomograph, comprising a magnet (1) for generating a homogeneous static magnetic field by means of a spatially homogeneous correction field, at least one auxiliary coil (2) to which a compensation current is applied, for correction of the static magnetic field, at least one gradient coil (3) for generating a gradient field varying in space and directed in the same direction as the static magnetic field, which gradient coil can be subjected to currents varying over time, and at least one rf coil arrangement (7, 8) to which rf pulses can be supplied for exciting nuclear spins of a body located in the homogeneous static magnetic field and permitting the resonance signals generated by the excited nuclear spins to be received, in which method the excitation of the nuclear spins is accomplished by means of a sequence of rf pulses comprising a first excitation pulse and a subsequent sequence of rf pulses serving for generating spin echoes, current pulses are applied to the at least one gradient coil in the intervals between successive rf pulses, and furthermore the influence of the eddy currents and other inaccuracies produced by the generation of the gradient fields is compensated,
characterized in that
the time interval between the excitation pulse (31) and the subsequent rf pulse (32) is adjusted to such a value different from half the time interval between the subsequent rf pulses (32, 33') which ensures that the dephasing effect on the excited nuclear spins resulting from the variation to which the static magnetic field is subjected by the insertion of the at least one gradient field is compensated at least approximately.

3. Method according to claim 1 or 2, characterized in that the value of the current pulse (74) or the variation of the time interval between the excitation pulse and the subsequent rf pulse, relative to half the time interval between the subsequent rf pulses, is proportional to the value of the at least one gradient field (64).

4. Method according to claim 3 using a phase gradient which is varied in value in steps at least once for each excitation, characterized in that the value of the current pulse (74) or the variation of the time interval between the excitation pulse and the subsequent rf pulse (32), relative to half the time interval between the subsequent rf pulses, is proportional to the value of the phase gradient (64).

5. Method according to claim 1 using a slice-selection gradient comprising in the time interval between the excitation pulse and the subsequent rf pulse a portion of inverse sign, characterized in that the current pulse (74) supplied to the auxiliary coil (2) is generated simultaneously with the appearance of the portion (44) of the inverse-sign portion of the slice-selection gradient.

6. Method according to any of the preceding claims using a phase gradient which is varied after each excitation during one or more of the time intervals of the sequence of rf pulses, characterized in that each variation of the phase gradient is associated to a current pulse supplied to the auxiliary coil.

7. Method according to claim 6, where the inverse-sign phase gradient is inserted during every time interval between two rf pulses before and after the appearance of the echo signal, characterized in that every time the phase gradient is inserted, a current pulse with a sign corresponding to the sign of the inserted phase gradient is supplied to the auxiliary coil, too.

8. Method according to any of the preceding claims, characterized in that the gradients which are to be inserted in the course of the rf pulse sequence are switched on at least once before irradiation of at least the first rf pulse sequence.

9. Nuclear spin tomograph comprising a magnet (1) for generating a homogeneous static magnetic field, at least one auxiliary coil (2) that can be supplied with a compensation current, for correction of the static magnetic field by means of a spatially homogeneous correction field, first means (17, 21) for generating the current to be supplied to the auxiliary coil, at least one gradient coil (3) for generating a gradient field varying in space and directed in the same direction as the static magnetic field, second means (12, 25) for supplying the at least one gradient coil with currents varying over time, at least one rf coil arrangement (7), third means (14, 15, 16) for generating rf pulses which can be supplied to the rf coil arrangement for exciting the nuclear spins of a body located in the homogeneous static magnetic field and which include a first excitation pulse and a subsequent sequence of rf pulses which serve for generating spin echoes, and fourth means (8, 17, 18) for receiving the resonance signals generated by the excited nuclear spins,
characterized in that
the second means (12, 25) is adapted for generating a signal characteristic of the strength and/or duration, of the current supplied to the at least one gradient coil and that, for carrying out the method according to any of the preceding claims, the said signal is supplied to the first means (23, 24) for controlling the current supplied to the auxiliary coil (22) and, respectively, to the third means for controlling the time interval between the first and the second rf pulse.

10. Nuclear spin tomograph according to claim 9, characterized in that the first means comprises a gate circuit (22) and a first power amplifier (24) feeding the auxiliary coil (2), while the second means (12, 25) is adapted for generating current pulses and comprises a second power amplifier (25) feeding the gradient coil to which the current pulses are supplied for generating the gradient field and that the current pulses are further supplied to the gate circuit (23) of the first means (23, 24) which transmits selected current pulses to the first power amplifier (24) whose amplification factor is adjusted to the desired relationship between the currents flowing through the gradient coil and the auxiliary coil.

11. Nuclear spin tomograph according to claim 9, characterized in that said third means comprises a timing element for controlling the duration of the time interval between the excitation pulse and the subsequent rf pulse, that said second means is arranged to generate current pulses and comprises a power amplifier feeding said gradient coil to which the current pulses for generating the gradient field are supplied, and that in addition the current pulses are supplied to the timing element of said third means which timing element effects a variation of the duration of said time interval in proportion to the value of the respective current pulse.

## Revendications

1. Procédé pour former des suites d'impulsions spin-écho avec un tomographe à spin nucléaire, comportant un aimant (1) pour produire un champ magnétique statique homogène, au moins une bobine auxiliaire (2) alimentée par un courant de compensation pour la correction du champ magnétique statique par un champ de correction spatialement homogène, au moins une bobine de gradient (3) pour produire un champ de gradient spatialement variable, de même orientation que le champ magnétique statique, qui peut être alimentée par des courants temporellement variables, et au moins un agencement de bobines HF (7, 8) auquel peuvent être envoyées des impulsions HF pour exciter les spins nucléaires d'un corps situé dans le champ magnétique statique homogène et qui permet la réception des signaux de résonance produits par les spins nucléaires excités, procédé dans lequel l'excitation des spins nucléaires est réalisée au moyen d'une suite d'impulsions HF qui comporte une première impulsion d'excitation et une suite subséquente d'impulsions HF qui servent à la production de spin-échos, des impulsions de courant sont envoyées dans les intervalles entre les impulsions HF successives de la ou des bobines de gradient et en outre l'influence des courants parasites produits par l'établissement des champs de gradient et d'autres inexactitudes est compensée,
caractérisé en ce que l'on envoie à la bobine auxiliaire (2), au moins dans l'intervalle temporel entre l'impulsion d'excitation (31) et l'impulsion HF suivante (32) ou seulement entre les impulsions HF, une impulsion de courant (74) qui entraîne une modification temporellement limitée et spatialement homogène du champ magnétique statique telle que l'effet déphasant sur les spins nucléaires excités, qui est déterminé par la modification subie par le champ magnétique statique du fait de la mise en service du ou des champs de gradient (64), est au moins sensiblement supprimé.

2. Procédé pour former des suites d'impulsions spin-écho avec un tomographe à spin nucléaire, comportant un aimant (1) pour produire un champ magnétique statique homogène par un champ de correction spatialement homogène, au moins une bobine auxiliaire (2) alimentée par un courant de compensation pour la correction du champ magnétique statique, au moins une bobine de gradient (3) pour produire un champ de gradient spatialement variable, de même orientation que le champ magnétique statique, qui peut être alimentée par des courants temporellement variables, et au moins un agencement de bobines HF (7, 8) auquel peuvent être envoyées des impulsions HF pour exciter les spins nucléaires d'un corps qui se trouve dans le champ magnétique statique homogène et qui permet la réception des signaux de résonance produits par les spins nucléaires excités, procédé dans lequel l'excitation des spins nucléaires est réalisée au moyen d'une suite d'impulsions HF qui comporte une première impulsion d'excitation et une suite subséquente d'impulsions HF qui servent à la production de spin-échos, des impulsions de courant sont envoyées dans les intervalles entre les impulsions HF successives de la ou des bobines de gradient et en outre l'influence des courants parasites produits par l'établissement des champs de gradient et d'autres inexactitudes est compensée,
caractérisé en ce que la distance entre l'impulsion d'excitation (31) et l'impulsion HF suivante (32) est ajustée à une valeur qui s'écarte de la moitié de la distance entre les impulsions HF successives (32, 33') telle que l'effet déphasant sur les spins nucléaires excités, qui est déterminé par la modification subie par le champ magnétique statique du fait de la mise en service du ou des champs de gradient, est au moins sensiblement supprimé.

3. Procédé selon la revendication 1 ou 2, caractérisé en ce que l'amplitude de l'impulsion de courant (74) ou la modification de la distance entre l'impulsion d'excitation et l'impulsion HF suivante par rapport à la moitié de la distance entre les impulsions HF suivantes est proportionnelle à l'intensité du ou des champs de gradient (64).

4. Procédé selon la revendication 3, dans lequel on utilise un gradient de phase dont l'amplitude est modifiée par pas au moins une fois pour chaque excitation, caractérisé en ce que l'amplitude de l'impulsion de courant (74) ou la modification de la distance entre l'impulsion d'excitation et l'impulsion HF (32) suivante par rapport à la moitié de la distance entre les impulsions HF suivantes est proportionnelle à l'amplitude du gradient de phase (64).

5. Procédé selon la revendication 1, dans lequel on utilise un gradient de sélection en tranches qui présente une partie à signe inversé dans l'intervalle temporel entre l'impulsion d'excitation et l'impulsion HF suivante, caractérisé en ce que l'impulsion de courant (74) envoyée à la bobine auxiliaire (2) est produite en même temps que l'apparition de la partie (44) à signe inversé du gradient de sélection en tranches.

6. Procédé selon l'une des revendications précédentes, utilisant un gradient de phase qui est modifié après chaque excitation dans un ou plusieurs des intervalles de la suite d'impulsions HF, caractérisé en ce qu'une impulsion de courant envoyée à la bobine auxiliaire est associée à chaque modification du gradient de phase.

7. Procédé selon la revendication 6, dans lequel le gradient de phase est mis en service avec un signe opposé dans chaque intervalle entre deux impulsions HF avant et après l'apparition du signal d'écho, caractérisé en ce que, lors de chaque mise en service du gradient de phase, une impulsion de courant de signe correspondant au signe du gradient de phase mis en service est envoyée aussi à la bobine auxiliaire.

8. Procédé selon l'une des revendications précédentes, caractérisé en ce qu'avant l'émission de la première suite d'impulsions HF au moins, les gradients qui doivent être mis en service pendant le déroulement de la suite d'impulsions HF sont mis en service au moins une fois.

9. Tomographe à spin nucléaire comportant un aimant (1) pour produire un champ magnétique statique homogène, au moins une bobine auxiliaire (2) qui peut être alimentée par un courant de compensation pour la correction du champ magnétique statique par un champ de correction spatialement homogène, un premier dispositif (17, 21) pour produire le courant qui doit être envoyé à la bobine auxiliaire, au moins une bobine de gradient (3) pour produire un champ de gradient spatialement variable, de même orientation que le champ magnétique statique, un second dispositif (12, 25) pour envoyer des courants temporellement variables à la bobine de gradient ou aux bobines de gradient, au moins un agencement de bobines HF (7), un troisième dispositif (14, 15, 16) pour produire des impulsions HF qui peuvent être envoyées à l'agencement de bobines HF pour exciter les spins nucléaires d'un corps qui se trouve dans le champ magnétique statique homogène et qui comportent une première impulsion d'excitation et une suite consécutive d'impulsions HF qui servent à la production de spin-échos, et un quatrième dispositif (8, 17, 18) pour recevoir les signaux de résonance produits par les spins nucléaires excités,
caractérise en ce que le second dispositif (12, 25) est agencé pour produire un signal caractéristique de l'intensité et/ou de la durée du courant envoyé à la bobine de gradient ou aux bobines de gradient et ce signal pour la mise en oeuvre du procédé selon l'une des revendications précédentes est envoyé au premier dispositif (23, 24) pour commander le courant envoyé à la bobine auxiliaire (22), ou au troisième dispositif pour commander la distance entre la première et la seconde impulsion HF.

10. Tomographe à spin nucléaire selon la revendication 9, caractérisé en ce que le premier dispositif comporte un circuit porte (22) et un premier amplificateur de puissance (24) qui alimente la bobine auxiliaire (2) et le second dispositif (12, 25) est agencé pour produire des impulsions de courant et comporte un second amplificateur de puissance (25) qui alimente la bobine de gradient et auquel sont envoyées les impulsions de courant pour produire le champ de gradient, et en ce que les impulsions de courant sont envoyées en outre au circuit porte (23) du premier dispositif (23, 24) qui transmet des impulsions de courant choisies au premier amplificateur de puissance (24) dont le facteur d'amplification est ajusté en fonction du rapport voulu des courants traversant la bobine de gradient et la bobine auxiliaire.

11. Tomographe à spin nucléaire selon la revendication 9, caractérisé en ce que le troisième dispositif comporte un organe de temporisation commandant la distance temporelle entre l'impulsion d'excitation et l'impulsion HF suivante et le second dispositif est agencé pour produire des impulsions de courant et comporte un amplificateur de puissance alimentant la bobine de gradient et auquel sont envoyées les impulsions de courant pour produire le champ de gradient, et en ce que les impulsions de courant sont envoyées en outre à l'organe de temporisation du troisième dispositif qui provoque une modification de la taille de l'intervalle temporel cité proportionnellement à l'amplitude de l'impulsion de courant respective.
